(19) **Europäisches Patentamt**

**European Patent Office**

**Office européen des brevets**

(11) **EP 0 885 859 B1**

(12) **EUROPEAN PATENT SPECIFICATION**

(45) Date of publication and mention
of the grant of the patent:
**13.03.2002 Bulletin 2002/11**

(51) Int Cl.[7]: **C04B 35/575**, C30B 31/10,
C30B 31/14, H01L 21/02,
C04B 35/628

(21) Application number: **98304757.2**

(22) Date of filing: **17.06.1998**

(54) **Member for semiconductor equipment**

Bauteil für Halbleiterapparatur

Membre pour un équipement de semiconducteur

(84) Designated Contracting States:
**DE FR GB**

(30) Priority: **20.06.1997 JP 16478397**

(43) Date of publication of application:
**23.12.1998 Bulletin 1998/52**

(73) Proprietor: **BRIDGESTONE CORPORATION**
**Tokyo 104-0031 (JP)**

(72) Inventors:
• **Takahashi, Yoshitomo**
**Chuo-ku, Tokyo (JP)**
• **Wada, Hiroaki**
**Chuo-ku, Tokyo (JP)**
• **Miyamoto, Taro**
**Chuo-ku, Tokyo (JP)**

(74) Representative: **Spoor, Brian et al**
**Lewis & Taylor**
**144 New Walk**
**Leicester LE1 7JA (GB)**

(56) References cited:
**WO-A-98/39270**            **US-A- 4 619 798**

## Description

The present invention relates to a member for a semiconductor equipment, and in particular to a member for a semiconductor equipment in which a silicon carbide sintered body having excellent characteristics is used, which has excellent durability, and which has high characteristics.

A member for a semiconductor equipment includes a soaking tube (liner tube) used for manufacturing a semiconductor, a reaction tube (process tube) for flowing reaction gas, a jig (wafer boat) for disposing a semiconductor wafer, or the like. Because the member needs to have high denseness, high heat resistance, high rigidity, and the like, the use of silicon carbide tends to increase. Conventionally, in a case in which the member for a semiconductor equipment is made from silicon carbide, it is in general that binder is added to raw material powder so as to form a molding, that the molding is calcined and sintered, and afterwards is impregnated with melted metal silicon.

Conventionally, in the member for a semiconductor equipment in which silicon carbide is used, since metal impurities within the silicon carbide move diffusingly within the member at the time of high temperature processing, there is a drawback in that a semiconductor wafer is contaminated. In order to prevent the contamination of the wafer caused by the impurities in the silicon carbide, a method of manufacturing a member from a highly pure material, a method of forming a highly pure silicon carbide coating on the surface of a member through CVD (chemical vapor deposition) processing, or the like is implemented.

However, even if the highly pure silicon carbide which contains the metal impurities in the order of several ppm or less, it is necessary to purify the porous sintered body before it is impregnated with the metal silicon. Further, there is a drawback in that the metal silicon is eluted from the sintered body impregnated with the metal silicon during a process for pickling or acid treatment. Thus, in order to further improve the purity and durability, the CVD processing in which the surface of the member is coated with a silicon carbide coating is carried out. However, a large amount of money is required for the equipment in the CVD processing and the manufacturing cost increases. Further, due to the repetition of a cycle of rapid heating and rapid cooling, the CVD coating may be peeled from a base material, or alternatively, a pinhole or a cracking may be generated on the coating. A drawback arises in that the durability against contamination is insufficient.

Moreover, the base material which is subjected to the CVD processing is molded in advance in the shape of a jig by means of cast-molding or the like through a reaction sintering method. However, since the size of the wafer is increased and the configuration of the reaction tube is changed in recent years, various configurations of the base materials are requested and it is necessary to manufacture a mold for every member. This is an additional factor of increasing the manufacturing cost.

It is known from not prepublished WO-A-98/39270 to use a silicon carbide sintered body as a dummy wafer for a semi-conductor. The silicon carbide sintered body is . formed by sintering a mixture in which e.g. aluminium is added to silicon carbide particles. As a result, the amount of e.g. aluminium impurities contained in the silicon carbide sintered body produced thereby is higher than is desired.

Semiconductor furnace parts made by molding SiC containing a sintering aid such as boron carbide or boron, followed by purification, sintering and coating with a SiC film by CVD is known from US-A-4 619 798.

The present invention was developed in view of the above drawbacks, and the object thereof is to provide a member for a semiconductor equipment in which a highly dense and highly pure silicon carbide sintered body is used, in which the contamination of a wafer or the like due to metal impurity can be prevented, in which productivity is good and manufacturing cost is low, and in which durability and solvent resistance are excellent.

As a result of the present inventors' extensive studies on the circumstances of developing the aforementioned sintering method, an optimal amount of non-metal-based sintering additive, e.g., carbon, is disposed appropriately on the surface of silicon carbide powder beforehand and the silicon carbide powder is subjected to hot pressing under the specific conditions, such that a highly dense and highly pure silicon carbide sintered body is obtained. By using the silicon carbide sintered body, it has found that the member for a semiconductor equipment having excellent characteristics is obtained. The present invention was thus completed.

According to the present invention, a member for use in a semiconductor equipment is formed from a silicon carbide sintered body obtained by sintering a mixture of silicon carbide powder and a non-metal-based sintering additive, and the silicon carbide sintered body having a density of at least 2.9 g/cm$^3$ and a total content of impurity elements of 1 ppm or less. The specific resistance of the silicon carbide sintered body may be 1 $\Omega \cdot$ cm or less and the thermal conductivity thereof is at least 200 W/m k.

Because the highly pure and highly dense silicon carbide sintered body is used in the member for a semiconductor equipment of the present invention, the member does not contain metal silicon, and even if the member is heated at a temperature over 1500 °C, which is a melting point of silicon, the strength thereof is not reduced and the member is stable in the acid treatment. Moreover, because the member is easily subjected to electrical discharge machining, the member can be an assembly type. As a result, the degree of freedom of designing the member for a semiconductor equipment is increased, and even if a large size member is manufactured, it can be coped by a sintered body equipment having a conventional size.

Fig. 1A shows a side view of a side plate which is used for a horizontal type wafer boat which has been obtained by electrical discharge machining of a silicon carbide sintered body.

Fig. 1B shows a side view of a backing rod which is used for the horizontal type wafer boat.

Fig. 1 C shows a side view of a support post which is used for the horizontal type wafer boat.

Fig. 2A shows a side view of a handle, of a bracket, which is used for the horizontal type wafer boat which has been obtained by electrical discharge machining of a silicon carbide sintered body.

Fig. 2B shows a side view of a bracket which is attached to the side plate shown in Fig. 1A.

Fig. 2C shows a side view of a nut.

Fig. 2D shows a side view of a bolt.

Fig. 3 shows a schematic perspective view of the horizontal type wafer boat in Example 1.

DESCRIPTION OF THE PREFERRED EMBODIMENTS

The present invention will be described in detail hereinafter. At first, a silicon carbide sintered body which is an element of the member for use in a semiconductor equipment according to the present invention.

The silicon carbide sintered body used as a material of the member is made of silicon carbide powder, and the powder may be $\alpha$-type, $\beta$-type, amorphous silicon carbide powders or mixtures thereof. In particular, $\beta$-type silicon carbide powder is preferably used. The grade of the $\beta$-type silicon carbide powder is not particularly specified, and for example, $\beta$-type silicon carbide powder which is commercially available can be used. From the viewpoint of densification, it is preferable that the particle diameter of the silicon carbide powder be small and from about 0.01 to about 10 $\mu$m, and more preferably from about 0.05 to about 1 $\mu$m. If the particle diameter is less than 0.01 $\mu$m, it is not preferable since it is difficult to handle the silicon carbide powder during the measuring and mixing processes and the like. If the particle diameter exceeds 10 $\mu$m, it is not preferable since the specific surface area of the silicon carbide powder is small, i.e., the surface area thereof which makes contact with adjacent granules becomes small, and it is difficult to achieve densification.

As a preferable aspect of silicon carbide raw material powder, a silicon carbide powder in which the particle diameter is 0.05 to 1 $\mu$m, the specific surface area is 5 $m^2$/g or more, the free carbon is 1 % or less, and the oxygen content is 1 % or less is preferably used. Further, the particle size distribution of the silicon carbide powder to be used is not particularly limited, and from the viewpoints of improving the filling density of the powder and the reactivity of silicon carbide at the time of manufacturing the silicon carbide sintered body, silicon carbide powder having two or more size distribution peaks may be used.

In order to obtain a silicon carbide sintered body of high purity, the highly pure silicon carbide powder may be used as the raw material silicon carbide powder.

The highly pure silicon carbide powder can be obtained, for example, in accordance with a manufacturing method including a sintering process in which a solid material obtained by uniformly mixing a silicon source containing at least one type or more of a liquid silicon compound, a carbon source containing at least one type or more of a liquid organic compound which generates carbon upon heating, and a polymerizing or cross-linking catalyst, is carbonized through heating in a non-oxidizing atmosphere, and thereafter, sintered in a non-oxidizing atmosphere.

As a silicon compound (hereinafter occasionally referred to as "silicon sources") which is used in manufacturing the highly pure silicon carbide powder, the liquid and solid compounds can be used together. However, at least one type of compound must be selected from the liquid compounds. As the liquid compound, alkoxysilane (mono-, di-, tri-, tetra-) and polymers of tetraalkoxysilane is used. Among alkoxysilanes, tetraalkoxysilane is preferably used, and more concretely, methoxysilane, ethoxysilane, propoxysilane, butoxysilane, or the like can be used. Regarding handling, ethoxysilane is preferable. Moreover, as the polymer of tetraalkoxysilane, low molecular weight polymer (oligomer) which has a polymerization degree of about 2 to 15 and a liquid silicic acid polymer whose polymerization degree is even higher can be used. As a solid compound which can be used with the liquid together, there can be silicon oxide. In the present invention, silicon oxide includes SiO, silica sol (colloidal hyperfine silica containing liquid, including an OH group or an alkoxyl group), silicon dioxide (silica gel, hyperfine silica, quartz powder), or the like.

Among the silicon sources, from the viewpoint of good uniformity and good handling ability, the tetraetoxysilane oligomer or the mixture of tetraetoxysilane oligomers and fine powder silica is preferable. Further, the highly pure materials are used for these silicon sources, and the initial content of impurity is preferably 20 ppm or less, and more preferably 5 ppm or less.

Further, as an organic compound which is used for manufacturing the silicon carbide powder and which generates carbon upon heating, a liquid compound or a combination of liquid and solid compounds can be used. It is preferable that an organic compound whose residual carbon ratio is high and which is polymerized or cross-linked by a catalyst or upon heating is, for example, a monomer or prepolymer of a resin such as phenol resin, furan resin, polyimide, polyurethane, polyvinyl alcohol, or the like. Other liquid compounds such as cellulose, sucrose, pitch, tar, or the like may be used, and especially, resol-type phenol resin is preferable. Further, the purity of the compound can be controlled and selected appropriately in accordance with purpose. In particular, in the case in which highly pure silicon carbide powder is needed, it is preferable to use an organic compound which does not contain 5 ppm or more of each metal.

When the silicon carbide powder, which is used as a raw material powder in the present invention, is manufactured, the mol ratio of carbon to silicon (hereinafter, "C/Si ratio") is defined by elemental analysis of a carbide intermediate obtained by carbonizing a mixture. Stoichiometrically, when C/Si ratio is 3.0, free carbon within the generated silicon carbide is 0 %. However, in reality, due to the vaporization of SiO gas which is generated simultaneously, free carbon generates in a low C/Si ratio. It is important to determine the blending ratio in advance such that the amount of the free carbon in the silicon carbide powder is a suitable amount for the sintered body made from the silicon carbide powder. Normally, in the sintering in approximately 1 atmospheric pressure and at 1600 °C or more, when the C/Si ratio is 2.0 to 2.5, the free carbon can be prevented and the range may be preferable. When C/Si ratio is 2.5 or more, the free carbon increases remarkably. However, because the free carbon has an effect of preventing particle growth, the range may be selected appropriately for the desired particle size. Because the C/Si ratio for obtaining pure silicon carbide varies depending on the atmospheric pressure during sintering, the C/Si ratio is not necessarily limited to the above range.

Because an action of the free carbon in the silicon carbide powder on sintering is very weak compared to that of the carbon generated by non-metal-based sintering additive coated on the surface of the silicon carbide powder used in the present invention, it can be basically ignored.

Moreover, in the present invention, in order to obtain a solid material in which a silicon source and an organic compound, which generates carbon upon heating, are mixed uniformly, the mixture of the silicon source and the organic compound may be hardened, as occasion demands, so as to form a solid material. As the hardening method, a cross-linking method upon heating, a hardening method through a hardening catalyst, a method using electron beams or radiation can be used. The hardening catalyst can be selected appropriately in accordance with a carbon source. In the case in which the carbon source is phenol resin or furan resin, acid groups such as toluenesulfonic acid, toluenecarboxylic acid, acetic acid, oxalic acid, hydrocholoric acid, sulfuric acid, or the like or amine groups such as hexamine or the like is used as the hardening catalyst.

The raw mixed solid can be heated and carbonized upon heating as occasion demands. The heating and carbonization of the solid is performed by heating the solid material at 800 °C to 1000 °C for 30 to 120 minutes in a non-oxidizing atmosphere of nitrogen, argon or the like.

Further, silicon carbide is generated by heating the carbide at a temperature of from 1350 °C to 2000 °C in a non-oxidizing atmosphere of argon or the like. The temperature and time for sintering can be selected appropriately in accordance with the desired characteristics such as particle diameter and the like. However, for more effective production, sintering at 1600 °C to 1900 °C is preferable.

Furthermore, when the powder with even higher purity is required, the heating process is carried out for 5 to 20 minutes at 2000 to 2100 °C at the time of the aforementioned sintering. In this way, impurities can be further removed.

From the above description, as a method of obtaining a silicon carbide powder whose purity is particularly high, a method of manufacturing a raw material powder for highly pure single crystals, which was described in Japanese Patent Application Laid-open (JP-A) No. 9-48605 (Japanese Patent Application No. 7-241856), can be used. The method of manufacturing the highly pure powder includes a process for producing silicon carbide powder and a process for post-treating the powder. In the process for producing silicon carbide powder, a silicon source and a carbon source are mixed uniformly and the obtained mixture is heated/sintered in a non-oxidizing atmosphere so as to obtain silicon carbide powder. The silicon source contains one or more compounds selected from the group consisting of highly pure tetraalkoxysilane, tetraalkoxysilane polymer, and oxidized silicon. And the carbon source is a highly pure organic compound which generates carbon upon heating. In the process for post-treating the powder, the powder is held at a temperature of 1700 °C or more to less than 2000 °C, and while the powder is held at this temperature, at least one heating process is carried out at 2000 °C or more to less than 2100 °C for 5 to 20 minutes. By performing the above two processes, the silicon carbide powder containing impurities at 0.5 ppm or less is obtained.

Further, when a silicon carbide sintered body which is used suitably for a member for use in a semiconductor equipment of the present invention is manufactured, as a non-metal-based sintering additive which is mixed with the above silicon carbide powder, a material which generates carbon upon heating, what is called a carbon source, is used. Examples thereof include organic compounds which generate carbon upon heating or silicon carbide powder (the particle diameter is about 0.01 to 1 μm) which is coated with the organic compounds. From the viewpoint of effects, the former is more preferable.

Specific examples of the organic compounds that generate carbon upon heating include coal tar pitch, tar pitch, phenol resins, furan resins, epoxy resins, phenoxy resins, and various saccharides including monosaccharides such as glucose, oligosaccharides such as sucrose, and polysaccharides such as cellulose and starch, having a high residual carbon ration. In order to mix with the silicon carbide powder uniformly, it is preferable to use organic compounds which are liquids at room temperature, organic compounds which can dissolve in solvents, or organic compounds which are softened or melted upon heating such as thermoplastic or thermally melting materials. Above all, phenol resins with which a molded product of a high strength can be obtained, particularly resol-type phenol resins, are desirable.

When these organic compounds are heated, it is assumed that inorganic carbon-based compounds such as carbon black or graphite are generated in the system and function effectively as sintering aids. Even if carbon black or graphite powder, which are conventionally known as carbon sintering aids, are added, the effects of the present invention which are obtained by adding the above non-metal-based sintering additives cannot be achieved.

In the present invention, when the mixture of silicon carbide powder and non-metal-based sintering additives is obtained, the non-metal-based sintering additives may be dissolved or dispersed in a solvent and the obtained solution or dispersion may be mixed with the silicon carbide powder. The solvent which is suitable for a compound to be used as non-metal-based sintering additive is preferable. Concretely, for phenol resin which is an organic compound which generates carbon upon suitable heating, lower alcohols such as ethyl alcohol or the like, ethyl ether, acetone or the like can be selected. Further, regarding these non-metal-based sintering additives and the solvent as well, it is preferable to use those having a low impurity content.

In the present invention, the surface of the silicon carbide powder may be coated with these non-metal-based sintering additives.

When the amount of the non-metal-based sintering additive mixed with the silicon carbide powder is too small, the density of the sintered body is not improved. When the amount of addition thereof is too large, free carbons increase and result in hindering densification. The amount depends on the type of non-metal-based sintering additives used, in general, the amount added is adjusted to 10 % by weight or less, and preferably 2 to 5 % by weight. The amount of addition can be estimated by determining the amount of silica (silicon oxide) on the surface of the silicon carbide powder with a hydrofluoric acid and by calculating stoichiometrically the added amount of non-metal-based sintering additive which amount is sufficient for the reduction of silica.

The amount of addition in the form of carbon is determined in consideration of the residual carbon ratio of the non-metal-based sintering additives after thermal decomposition of the aids (the proportion of carbon generated within the non-metal-based sintering additives), based on the premise that the silica quantified by the above method is reduced by the carbon generated from the non-metal-based sintering additives according to the following reaction formula.

$$SiO_2 + 3C \rightarrow SiC + 2CO$$

Further, in the silicon carbide sintered body relating to the present invention, it is preferable that the sum of carbon atoms derived from silicon carbide and carbon atoms derived from non-metal-based sintering additives, both of the silicon carbide and the additives are included in the silicon carbide sintered body, exceeds 30 % by weight and is 40 % by weight or less. If the content is 30 % by weight or less, the proportion of impurities in the sintered body increases. If the content exceeds 40 % by weight, the carbon content increases, the density of the obtained sintered body drops, and characteristics of the sintered body such as strength and oxidation resistance deteriorate, which is not preferable.

When the silicon carbide sintered body relating to the present invention is manufactured, at first, silicon carbide powder and non-metal-based sintering additives are mixed uniformly. As mentioned before, phenol resin which is a non-metal-based sintering additive is dissolved in a solvent such as ethyl alcohol and then the obtained solution is well mixed with the silicon carbide powder. The mixing can be carried out by known mixing means, e.g., a mixer, a planetary ball mill, or the like. The mixing is preferably carried out over 10 to 30 hours, and more particularly over 16 to 24 hours. After sufficient mixing, the solvent is removed at a temperature suited to its physical properties, e.g., 50 to 60 °C in the case of the previously-mentioned ethyl alcohol. The mixture is dried by evaporation and afterward is sieved so as to be obtained the raw material powder. From the viewpoint of purification, it is necessary that a ball mill container and a ball are made of a synthetic resin containing as little metal as possible. Moreover, a granulating device such as a spray drier or the like may be used for drying the powder.

The sintering process which is required in the method of manufacturing a member for use in a semiconductor equipment of the present invention is a process in which the mixture of powder or the molded body of the mixture of powder obtained by a molding process, to be described later, is placed and hot-pressed within a mold at a temperature of 2000 to 2400 °C, at a pressure of 300 to 700 kgf/cm$^2$, and in a non-oxidizing atmosphere.

From the viewpoint of the purity of the obtained sintered body, in order that the molded body does not directly contact the metal portion of the mold, it is preferable that a graphite material is used on some or all of the mold, which is used herein, or that a Teflon sheet or the like is interposed.

In the present invention, the pressure of hot pressing can be 300 to 700 kgf/cm$^2$. In the case in which pressure is 400kgf/cm$^2$ or more, there is the need to select parts for hot pressing, e.g., dies, punches, or the like, to be used herein, with high pressure resistance.

Here, the sintering process will be described in detail. Before the hot-pressing process for manufacturing a sintered body, it is preferable that heating and temperature-raising are carried out under the following conditions so as to sufficiently remove impurities and to complete carbonization of the carbon source. Then, it is preferable that hot-pressing under the above conditions is performed.

Namely, the following two-stage temperature-raising process is preferably effected. Firstly, the interior of a furnace is heated slowly from room temperature to 700 °C in a vacuum. If it is difficult to control the temperature within the high temperature furnace, the temperature can be raised continuously to 700 °C. Preferably, the pressure inside a furnace is reduced to $10^{-4}$ torr, and the inside temperature is raised slowly from room temperature to 200 °C and held thereat for a fixed time. Thereafter, the temperature is continuously raised slowly to 700 °C and kept there for a fixed time. In the first temperature-raising process, absorbed water or organic solvents are released, and moreover the non-metal based sintering additive bonding is carbonized by thermal decomposition. A suitable period of time over which the temperature is held at around 200 °C or at around 700 °C is selected in accordance with the size of the sintered body. The point in time when the lowering in the degree of the vacuum becomes small to some extent, is taken as an indication of whether the holding time is sufficient or not. If rapid heating is effected at this stage, it is not preferable since the removal of impurities or carbonization of the carbon source cannot be effected sufficiently and cracking or holes may appear in the molded body.

For example, regarding a sample of about 5 to 10 g, the pressure inside the furnace is reduced to $10^{-4}$ torr, the temperature is raised slowly from room temperature to 200 °C and is held thereat for about 30 minutes. Thereafter, the temperature is continuously raised slowly to 700 °C. The time period over which the temperature is raised from room temperature to 700 °C is about 6 to 10 hours, and preferably around 8 hours. Further, it is preferable that the temperature is held at around 700 °C for about 2 to 5 hours.

In a vacuum, the temperature is raised from 700 °C to 1500 °C over about 6 to 9 hours under the above conditions and is held at 1500 °C over about 1 to 5 hours. In this process, it is thought that silicon dioxide and silicon oxide are reduced. In order to remove oxygen attached to the silicon, the reduction goes fully to completion. It is necessary that the temperature is held at 1500 °C until the generation of carbon monoxide, which is a by-product of the reduction, is completed, i. e., the decrease in the degree of vacuum becomes small and the degree of vacuum is recovered to a degree in the vicinity of 1300 °C; the temperature before reduction. By the reduction in the second temperature-raising process, silicon dioxide, which adheres to the surface of the silicon carbide powder, prevents densification and causes the growth of oversized particles, is removed. Gas which includes SiO and CO generated during the reducing reaction includes impurity elements. However, the gas generated is constantly evacuated from the reaction furnace with a vacuum pump. Accordingly, from the viewpoint of purification, it is preferable that the temperature is held sufficiently.

After the temperature-raising process is finished, highpressure hot pressing is preferably carried out. When the temperature is raised above 1500 °C, sintering starts. At that time, in order to prevent particles from growing abnormally, pressure is applied at 300 to 700 kgf/cm$^2$. Thereafter, in order to make the interior of the furnace a non-oxidizing atmosphere, inert gas is introduced thereto. As the inert gas, nitrogen or argon is used. Since argon is not reactive at high temperatures, argon gas is preferably used.

After the interior of the furnace is made non-oxidizing, the furnace is heated and is applied pressure so that the inside temperature is 2000 to 2400 °C and the inside pressure is 300 to 700 kgf/cm$^2$. The degree of pressure can be determined according to the particle diameter of the raw material powder. When the particle diameter of the raw material powder is small, even if the pressure at the time of application is relatively small, a suitable sintered body is obtained. Further, the temperature is raised from 1500 °C to 2000-2400 °C, which is the maximum temperature, over 2 to 4 hours. Sintering proceeds rapidly at 1850 to 1900 °C. Further, this maximum temperature is held for 1 to 3 hours and then sintering is completed.

When the maximum temperature is less than 2000 °C, it is not preferable since densification is unsatisfactory. When the temperature exceeds 2400 °C, it is not preferable because there is a risk that the powder or the molded body raw material is sublimed (decomposed). Further, when the pressure applied is less than 500 kgf/cm$^2$, it is not preferable since densification is unsatisfactory. When the pressure applied is more than 700 kgf/cm$^2$, molds such as graphite molds may be broken, and thus, it is not preferable as regards the manufacturing efficiency.

In the sintering process, from the viewpoint of maintaining the purity of the obtained sintered body, the graphite mold, the thermal insulating material of the heating furnace, or the like used herein is preferably a highly pure graphite raw material. The highly-purified graphite raw material is used, concretely, graphite raw material baked sufficiently beforehand at a temperature of 2500 °C or more which material does not generate impurities at the sintering temperature is preferably used. Further, the highly-purified inert gas with few impurities is preferably used.

In the present invention, through the above-described sintering process, the silicon carbide sintered body having excellent characteristics can be obtained. From the viewpoint of densification of the finally-obtained sintered body, a molding process, which will be described later, may be effected in advance of the sintering process. The molding process which can be performed in advance of the sintering process is described herein. The molding process is the step in which raw material powder obtained by mixing uniformly silicon carbide powder and a carbon source, is placed in a mold, and then heated and pressured within the temperature range of 80 to 300 °C for 5 to 60 minutes and in which the molded body is adjusted beforehand. From the viewpoint of densification of the final sintered body, it is preferable that the mold is filled with the raw material powder extremely densely. This molding step allows to make bulky powder compact previously in filling the sample for the hot pressing. Accordingly, it facilitates production of a highly dense sintered body and a thick sintered body if the molding step is repeated.

The filled raw material powder is pressed within the range of 60 to 100 kgf/cm$^2$ at 80 to 300 °C, and preferably 120 to 140 °C for 5 to 60 minutes, preferably 20 to 40 minutes so that the density thereof is 1.5 g/cm$^3$ or more, and preferably 1.9 g/cm$^3$ or more. The molded body formed by the raw material powder is thereby obtained. As the average particle diameter of the powder is decreased, it is more difficult to improve the density of the molded body. For densification, it is preferable to use vibration packing for placing the powder in the mold. More specifically, the density is preferably 1.8 g/cm$^3$ or higher for the powder having the average particle diameter of about 1 μm, and 1.5 g/cm$^3$ or higher for the powder having the average particle diameter of about 0.5 μm. If the density of the particle diameter is less than 1.5 g/cm$^3$ or less than 1.8 g/cm$^3$, respectively, densification becomes a problem in the density of the finally-obtained sintered body.

Before the sintering process to follow, the molded body can be cut beforehand to fit into the hot press mold used. The molded body is disposed in a mold at 2000 to 2400 °C, and at a pressure of 300 to 700 kgf/cm$^2$, in a non-oxidizing atmosphere. The molded body is then subjected to a process for hot pressing, i.e., a sintering process. A silicon carbide sintered body having high density and purity is thereby obtained.

A silicon carbide sintered body generated as described above is sufficiently improved density thereof and the density thereof is 2.9 g/cm$^3$ or more. If the density of the obtained sintered body is less than 2.9 g/cm$^3$, it is not preferable because mechanical characteristics such as bending strength, fracture strength or the like, and electrical physical qualities are lowered, and additionally, particle numbers are increased and contaminating effect worsens. More preferably, the density of the silicon carbide sintered body is 3.0 g/cm$^3$ or more.

Further, if the obtained sintered body is porous, there are physical drawbacks in that heat resistance, oxidization resistance, chemical resistance and mechanical strength are poor, cleaning is difficult, minute cracking occurs and minute pieces become contaminants, and gas permeation occurs. Thus, the problem of application limitation becomes significant.

The total content of impure elements in the silicon carbide sintered body obtained in the present invention is 5 ppm or less, preferably 3 ppm or less, and more preferably 1 ppm or less. As far as application in the industrial field of semiconductors is concerned, the impurity content as defined through chemical analysis is merely a reference value. In practice, evaluation depends on whether the impurity is dispersed uniformly or locally. Therefore, those skilled in the art use a practical device in general and evaluate by various means the extent to which the impurity contaminates a wafer under predetermined heating conditions. In accordance with a method including a sintering process in which a solid material (which is obtained by uniformly mixing a liquid silicon compound, a liquid organic compound which generates carbon upon heating, and polymerizing or cross-linking catalyst) is carbonized through heating in a non-oxidizing atmosphere, and thereafter, sintered in a non-oxidizing atmosphere. The total content of the impurity element of the silicon carbide sintered body can be as low as 1 ppm or less. Here, the impurity elements are elements of groups 1 to 16 of the periodic table described in the IUPAC Inorganic Chemistry Nomenclature Revised Edition (1989), and having an atomic number of 3 or more, except for atomic numbers 6 to 8 and 14.

In addition, preferable physical properties of a silicon carbide sintered body obtained in the present invention are taken into consideration. For example, it is preferable that bending strength at room temperature is 50 to 65 kgf/mm$^2$, bending strength at 1500 'C is 55 to 80 kgf/mm$^2$, Young's modulus is $3.5 \times 10^4$ to $4.5 \times 10^4$, Vickers hardness is 2000 kgf/mm$^2$ or more, Poisson's ratio is 0.14 to 0.21, the coefficient of thermal expansion is $3.8 \times 10^{-6}$ to $4.2 \times 10^{-6}$ (°C$^{-1}$), the thermal conductivity is 150 W/m · K or more, the specific heat is 0.15 to 0.18 cal/g · °C, the thermal shock resistance is 500 to 700 ΔT°C, and the specific resistance is 1 Ω · cm or less.

In accordance with a purpose to be used, a silicon carbide sintered body, which is obtained in accordance with the above-described manufacturing method, is subjected to processings such as machining, polishing, cleaning, and the like so as to manufacture the member for a semiconductor equipment. As a method of machining the silicon carbide sintered body in a desirable shape, electrical discharge machining which uses electrical conductivity is preferably used.

A member which is machined and obtained and a machining method are described herein more specifically. Cutting out of a member from a raw material includes: linear cutting out by a wire electrical discharge machine or by a cutter of a diamond blade; and curve cutting out by the wire electrical discharge machine. Drilling includes: drilling of a circular hole by an electrical discharge drilling machine or a diamond grindstone grinding machine; drilling of a blind-end hole/a shoulder hole by a grinding machine or a profile electrical discharge machine; drilling of a non-cylindrical hole by a wire electrical discharge machine or a profile electrical discharge machine; machining of a threaded hole by a profile electrical discharge machine or a diamond tapping machine; machining of a male thread by a cylindrical grinding machine or a lathe using a diamond electrodeposited tip; planar machining by a diamond grindstone planar grinding machine or a lapping machine; grooving machining by a profile electrical discharge machine or a shape grinding machine; and the like. Because the silicon carbide sintered body which is a raw material of a member for a semiconductor equipment is conductive, there is an advantage in that the electrical discharge machining which has a wide range of machining can be applied to the member.

As the electrical discharge machine, e.g., the profile electrical discharge machine, the wire electrical discharge machine, the electrical discharge drilling machine, and the like, an ordinary electrical discharge machine for metal machining can be used. However, when the raw material relating to the member of the present invention is machined, the higher the output of a power supply, the easier the machining and the less the machining time. The power supply circuit is a stabilized circuit built-in type where the maximum instantaneous machining current is 50 A or more, the largest wire feeding speed is 15 m/min. or more, and a compede wire in which the diameter of the wire to be used is about 0.3 mm. Further, the electrical discharge machine of dipping process type is preferred to the spraying process type.

The jig can be integrally formed by the sintered body used herein. However, since the sintered body is homogeneous and highly pure, it is possible that several parts are manufactured and assembled so as to form a jig. In a case in which the CVD processing is effected, it is preferable that the jig is integrally formed for forming a uniform coating. In a present state, if the configuration of the jig is complicated, it is necessary to have complicated molds having various configurations as mentioned above, and further, when a portion of the member is broken, the entire member cannot be used. However, when the highly pure sintered body relating to the present invention is used, various parts can be machined easily by a known electrical discharge machining. Further, even if the portion of the part is broken, only the broken part can be replaced and the planar accuracy is easily improved (mirror-like finishing). The machining of the member in a desirable shape can be performed in the procedure of known machining: cutting out of parts; drilling; tapping; manufacturing of a fastener such as a bolt, nut, or the like; and mirror-like finishing. The member for a semiconductor equipment obtained in this way is provided for the use of the part for a semiconductor equipment, a semiconductor safety part, or the like.

A semiconductor equipment, in which the member for semiconductor equipment of the present invention is used, includes: an aligner; a resist processing equipment; a dry etching system; a cleaning equipment; a heat processing equipment; an ion implantor; a CVD system; a PVD system; a dicing equipment; and the like. An example of the part includes: a plasma electrode for a dry etching system; a protective ring (focus ring); a slit part for an ion implantor (aperture); a protective plate for an ion generating portion or a mass spectrometric analysis portion; a dummy wafer which is used at the time of processing of the wafer in a heat processing equipment or a CVD system; a heater in the heat processing equipment or the CVD system, in particular, a heater which directly heats the wafer from below; and the like.

When the silicon carbide sintered body serving as a raw material relating to the present invention is manufactured, as far as the above-described heating conditions are satisfied, there is no particular limitation in the equipment for manufacturing the sintered body or the like. If the pressure resistance of a mold for sintering is considered, a known heating furnace or a reactor can be used.

The contents of impurity elements is preferably 1 ppm or less in each of a silicon carbide powder which is the raw material powder of the present invention, a silicon source and a carbon source for manufacturing the raw material powder, and an inert gas which is used to produce the non-oxidizing atmosphere. However, as long as the purity is within the permissible range of purification during the heating and sintering processes, the purity is not necessarily limited to this value. Moreover, impurity elements are elements of groups 1 to 16 of the periodic table described in the IUPAC Inorganic Chemistry Nomenclature Revised Edition (1989), and having an atomic number 3 or more, except for atomic numbers 6 to 8 and 14.

EXAMPLES

The present invention will be described hereinafter concretely by giving Examples. As long as the scope of the present invention is not exceeded, the present invention is not limited to these Examples.

Example 1

[Manufacture of Molded Body]

90 g of highly pure silicon carbide powder (produced in accordance with the method which was applied as Japanese Patent Application Laid-open (JP-A) No. 9-48605 (Japanese Patent Application No. 7-241856), of average particle diameter 1.1 μm, of impurity content less than 5 ppm, and of silica content 1.5 % by weight) and a solution in which 9 g of highly pure liquid resol-type phenol resin having a water content of 20 % were dissolved in 200 g of ethanol, were stirred in a planetary ball mill for 18 hours until mixed fully. Thereafter, the mixture was dried off by evaporating the ethanol at 50 to 60 °C. The mixture was put through a 500 μ m sieve and uniform silicon carbide raw material powder was obtained. 8.5 g of raw material powder was put into a mold (30 mm φ) and pressed at 130 °C for 20 minutes. Accordingly, a molded body having a density of 2.1 g/cm$^3$ was obtained.

[Manufacture of Sintered Body]

The sintered body was placed in a graphite mold and subjected to hot pressing under the following conditions. As a hot press, a high frequency induction heating-type 100t hot press was used.

(Conditions of Sintering Process)

In a vacuum state of 10$^{-5}$ to 10$^{-4}$ torr, the temperature was raised from room temperature to 700 °C over 6 hours and held thereat for 5 hours (the first temperature-raising process).

In the vacuum state, the temperature was raised from 700 °C to 1200 °C over 3 hours, and was further raised from 1200 °C to 1500 °C over 3 hours and held thereat for an hour (the second temperature-raising process).

Moreover, pressure of 500 kgf/cm$^2$ was applied, and the temperature was raised from 1500 °C to 2200 °C over 3 hours in an argon atmosphere and held thereat for an hour (hot-pressing process).

The density of the obtained sintered body was 3.15 g/cm$^3$, the Vickers hardness thereof was 2300 kgf/mm$^2$, and the electrical specific resistance thereof was 0.02 Ω · cm. The metal impurity content was less than 0.1 ppm.

Further, as a result of measuring in detail the physical properties of the sintered body which was obtained in Example 1, characteristics other than those given above were described as follows: the bending strength at room temperature was 57 kgf/mm$^2$; the bending strength at 1500 °C was 60 kgf/mm$^2$; the Young's modulus was $4.1 \times 10^4$; the Poisson's ratio was 0.15; the coefficient of thermal expansion was $3.9 \times 10^{-6}$°C$^{-1}$ the thermal conductivity was 200 W/m · k or more; the specific heat was 0.16 cal/g · °C; and the thermal shock resistance was 530 ΔT°C. It was confirmed that all of the aforementioned desirable physical properties were satisfied.

[Manufacture of Member for Semiconductor Equipment]

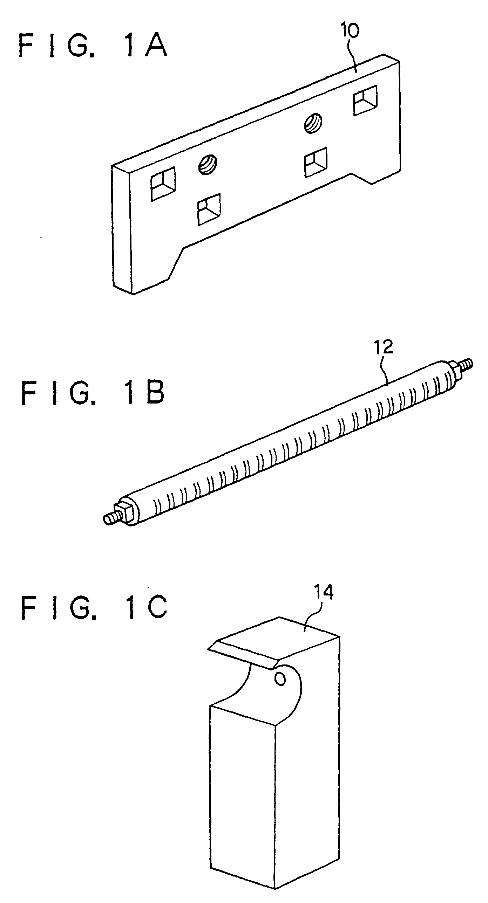

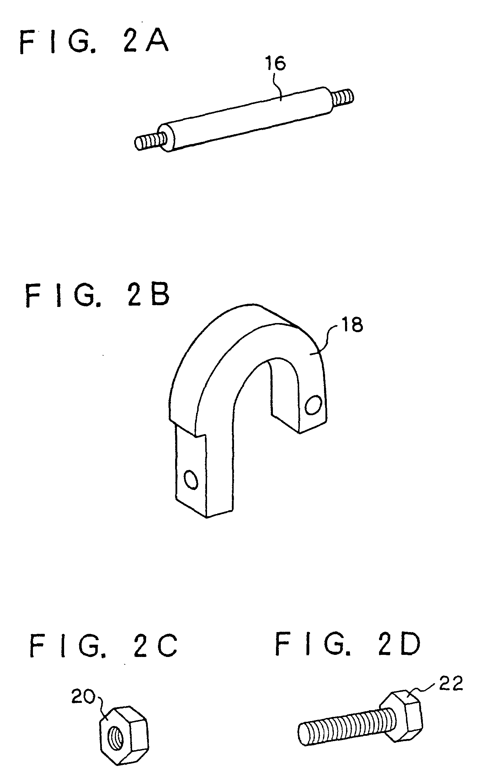

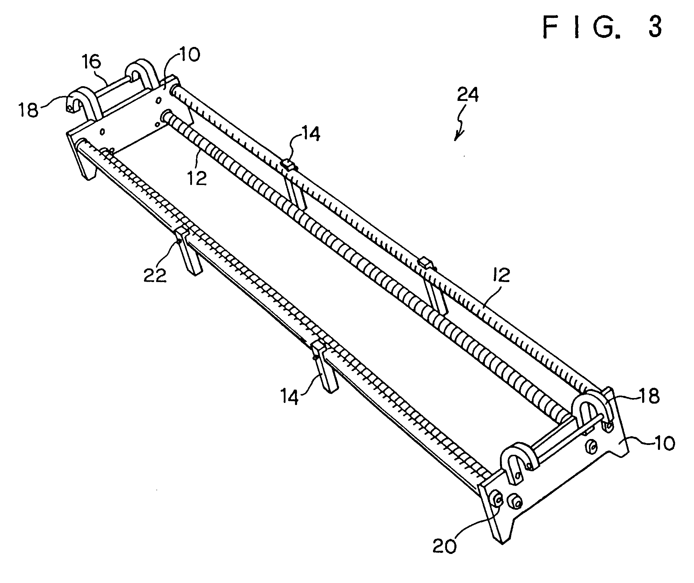

The obtained sintered body was subjected to electrical discharge machining so as to manufacture members shown in Figs. 1A, 1B, 1C, 2A, 2B, 2C, and 2D. The members were assembled and a horizontal type wafer boat shown in Fig. 3 was manufactured. Fig. 1A shows a perspective view of a side plate 10 which is used in the horizontal type wafer boat. Fig. 1B shows a perspective view of a backing rod 12 which is used in the horizontal type wafer boat, which has a threading portion at both ends, and which has an outer diameter of 6 mm and a length of 600 mm. Fig. 1 C shows a perspective view of a support post 14 which is attached to a plurality of places of the backing rod 12 for supporting it. Fig. 2A shows a perspective view of a handle 16 which is attached to a bracket 18. Fig. 2B shows a perspective view of a bracket 18 which is attached to the side plate 10 shown in Fig. 1A. Fig. 2C shows a perspective view of a nut 20 which is used for connecting the side plate 10 and the backing rod 12 and for attaching the bracket 18, the handle 16, and the like. Fig. 2D shows a perspective view of a bolt 22 for attaching the bracket 18 to the side plate 10. Moreover, Fig. 3 shows a schematic perspective view of a horizontal type wafer boat 24.

[Evaluations of Member for Semiconductor Equipment]

(Contaminating Effect)

A wafer (8 inches) was disposed in the wafer boat and an oxide coating was formed on the wafer in a diffusion furnace at 1050 °C. The number of iron atoms within 1 μm of the surface of the oxide coating was measured. The number in the volume (1 μ m × 1 cm$^2$) was $3.0 \times 10^{12}$ atoms. This showed the wafer boat hardly contaminated the wafer, i.e., the contaminating effect thereof was negligibly small.

(Durability)

The obtained member was placed into the diffusion furnace. In the presence of air, the temperature was raised to 1250 °C at the rate of 20 °C/min. and held thereat for thirty minutes. Then, the temperature was lowered to 800 °C at 15 °C/min. This raising and lowering cycle was repeated ten times. Thereafter, an operator checked visually whether a cracking, a pinhole, or the like was generated on the surface of the member. The generation of the cracking, pinhole, or the like on the surface was not recognized and the degradation of the surface due to the repetition of the raising and lowering temperature was not able to be seen.

(Solvent Resistance)

The weight of the obtained member was measured and then the member was washed thirty times by hydrofluoric acid. The weight of the washed member and the amount of decrease in weight were estimated. The decrease in weight of the member was not recognized before and after the washing and it was proved that the member had excellent solvent resistance.

Example 2

[Manufacture of Sintered Body]

8.5 g of silicon carbide raw material powder which was obtained in the same way as Example 1 was filled in a mold used in Example 1 and pressed. Without performing a process for obtaining a molded body, the powder was directly filled in a graphite mold and subjected to hot pressing under the conditions which are the same as those of Example 1. As a hot press, the device which is the same as the one in Example 1 was used.

(Conditions of Hot Pressing)

In a vacuum state of $10^{-5}$ to $10^{-4}$ torr, the temperature was raised from room temperature to 700 °C over 8 hours and held thereat for an hour (first temperature-raising process).

In the vacuum state, the temperature was raised from 700 °C to 1200 °C over 3 hours, and was further raised from 1200 °C to 1500 °C over 3 hours and held thereat for 4 hours (second temperature-raising process).

Moreover, pressure of 500 kgf/cm² was applied, and the temperature was raised from 1500 °C to 2200 °C over 4 hours in an argon atmosphere and held thereat for an hour (hot-pressing process).

The density of the obtained sintered body was 3.05 g/cm³, the Vickers hardness thereof was 2500 kgf/mm², and the electrical specific resistance thereof was 0.03 $\Omega \cdot$ cm.

[Manufacture and Evaluations of Member for Semiconductor Equipment]

The obtained sintered body was used and a member (wafer boat) for a semiconductor equipment was manufactured in the same manner as Example 1. The evaluations were made in the same way as Example 1. The data evaluating contaminating effect was 8.3 $\times 10^{12}$ atoms. It was confirmed that the durability and the solvent resistance of Example 2 were as excellent as those of Example 1.

Comparative Example 1

85 % by weight of commercially available silicon carbide powder and 15 % by weight of carbon powder were mixed so as to form a member which is the same as the one in Example 1. Thereafter, the member was placed in a calcination furnace and heated in a nitrogen gas up to 900 °C so as to obtain a calcinated body. Next, the calcinated body was placed in a sintering furnace and heated at 1550 °C. A metal silicon was impregnated so as to complete the sintering. The sintered body obtained as such was cast-molded so as to obtain a wafer boat.

The density of the obtained sintered body was 3.02 g/cm², the Vickers hardness thereof was 2000 kgf/mm², and the electrical specific resistance thereof was 1.0 $\times 10^{-3}$ $\Omega \cdot$ cm.

[Evaluations of Member for Semiconductor Equipment]

The evaluations of the obtained member (wafer boat) for a semiconductor equipment was made in the same way as Example 1.

The data evaluating contaminating effect was 1.1 $\times 10^{16}$ atoms and this showed that the contaminating effect was significant. Further, regarding the durability, cracking occurred at connecting portions when the temperature was raised eight times. Regarding the solvent resistance, the weight is decreased by 15 % and a defect was observed at a wafer implanted portion. Thus, both the durability and the solvent resistance were insufficient.

Comparative Example 2

On the surface of the wafer boat which was obtained in Comparative Example 1 by cast-molding, a silicon carbide coating is formed through CVD processing at 1000 °C with methyltrichlorosilane serving as raw material gas. The thickness of the coating was 10 to 100 µm.

[Evaluations of Member for Semiconductor Equipment]

The evaluations of the obtained member (wafer boat) for a semiconductor equipment were made in the same way as Example 1. The data evaluating contaminating effect was 4.6 $\times 10^{12}$ atoms and this shows that the contaminating effect thereof was negigibly small. Further, regarding the durability, cracking was observed on the surface when the temperature was raised seven times and cracking occurred at connecting portions when the temperature was raised eight times. Accordingly, the durability was insufficient. Regarding the solvent resistance, the weight loss was not observed after the member was washed by hydrofluoric acid. Thus, the solvent resistance was excellent.

As is obviously seen in each of the above Examples and Comparative Examples, the member for a semiconductor equipment in each of Examples 1 and 2, which was obtained in accordance with the method of the present invention, could be easily manufactured by assembling the parts through electrical discharge machining and grinding. Also, it was found that the durability and the solvent resistance of the member were excellent and the contaminating effect thereof was negligibly small. On the other hand, in the member for a semiconductor equipment in Comparative Example 1, which was obtained in accordance with the conventional method, the durability and the solvent resistance of the member were insufficient and the contaminating effect thereof was significant. Further, in the member for a semiconductor equipment in Comparative Example 2, in which the coating is formed on the surface through CVD processing, the solvent resistance of the member was excellent and the contaminating effect thereof was negligibly small. However, it was complicated to manufacture the member, and the durability thereof was poor due to the lack of strength of the coating.

In this way, the member for a semiconductor equipment of the present invention exhibits excellent characteristics as the assembly type member. Therefore, even if there is a request for a large size member due to the increase in size of a wafer and the like in recent years, it can be coped with the request without increasing the size of a sintered body equipment.

## Claims

1. A member for use in a semiconductor equipment, the member being formed from a silicon carbide sintered body obtained by sintering a mixture of silicon carbide powder and a non-metal-based sintering additive, the silicon carbide sintered body having a density of at least 2.9 g/cm$^3$ is **characterised in that** it has a total content of impurity elements of 1 ppm or less.

2. A member for use in a semi-conductor equipment according to Claim 1, wherein said non-metal-based sintering additive is an organic compound which generates carbon upon heating.

3. A member for use in a semi-conductor equipment according to Claim 1, wherein the surface of the silicon carbide powder is coated with said non-metal-based sintering additive.

4. A member for use in a semi-conductor equipment according to any of Claims 1 through 3, wherein said non-metal-based sintering additive contains an organic compound which generates carbon upon heating and silicon carbide powder, and the surface of the silicon carbide powder is coated with the organic compound.

5. A member for use in a semi-conductor equipment according to any of Claims 1 through 4, wherein said non-metal-based sintering additive is a phenol resin.

6. A member for use in a semi-conductor equipment according to any of Claims 1 through 5, wherein the specific resistance of said silicon carbide sintered body is 1 Ω · cm or less.

7. A member for use in a semi-conductor equipment according to any of Claims 1 through 6, wherein the thermal conductivity of said silicon carbide sintered body is at least 200 W/m · k.

8. A member for use in a semi-conductor equipment according to any of Claims 1 through 7, wherein said member for a semi-conductor equipment is an assembly type.

## Patentansprüche

1. Element zur Verwendung in einer Halbleiterapparatur, wobei das Element aus einem Siliciumcarbid-Sinterkörper besteht, der durch Sintern eines Gemisches aus Siliciumcarbidpulver und einem nicht Metall basierten Sinteradditiv erhalten wird, wobei der Siliciumcarbid-Sinterkörper, der eine Dichte von mindestens 2,9 g/cm$^3$ aufweist, **dadurch gekennzeichnet ist, dass** er einen Gesamtgehalt an Verunreinigungselementen von 1 ppm oder weniger aufweist.

2. Element zur Verwendung in einer Halbleiterapparatur nach Anspruch 1, bei welchem das nicht Metall basierte Sinteradditiv eine organische Verbindung ist, die beim Erhitzen Kohlenstoff erzeugt.

3. Element zur Verwendung in einer Halbleiterapparatur nach Anspruch 1, bei welchem die Oberfläche des Siliciumcarbidpulvers mit dem nicht Metall basierten Sinteradditiv beschichtet ist.

4. Element zur Verwendung in einer Halbleiterapparatur nach einem der Ansprüche 1 bis 3, bei welchem das nicht Metall basierte Sinteradditiv eine organische Verbindung, die beim Erhitzen Kohlenstoff erzeugt, sowie Siliciumcarbidpulver enthält, und die Oberfläche des Siliciumcarbidpulvers mit der organischen Verbindung beschichtet ist.

5. Element zur Verwendung in einer Halbleiterapparatur nach einem der Ansprüche 1 bis 4, bei welchem das nicht Metall basierte Sinteradditiv ein Phenolharz ist.

6. Element zur Verwendung in einer Halbleiterapparatur nach einem der Ansprüche 1 bis 5, bei welchem der spezifische Widerstand des Siliciumcarbid-Sinterkörpers 1 Ω • cm oder weniger beträgt.

7. Element zur Verwendung in einer Halbleiterapparatur nach einem der Ansprüche 1 bis 6, bei welchem die Wärmeleitfähigkeit des Siliciumcarbid-Sinterkörpers mindestens 200 W/m • k beträgt.

8. Element zur Verwendung in einer Halbleiterapparatur nach einem der Ansprüche 1 bis 7, wobei das Element für eine Halbleiterapparatur vom zusammengesetzten Typ ist.

un équipement à semiconducteurs est un type d'assemblage.

## Revendications

1. Élément destiné à être utilisé dans un équipement à semiconducteurs, l'élément étant formé d'un corps fritté en carbure de silicium obtenu par frittage d'un mélange d'une poudre de carbure de polysilicium et d'un additif de frittage non basé sur un métal, le corps fritté en carbure de silicium ayant une densité égale à au moins 2,9 g/cm$^3$ est **caractérisé en ce que** sa teneur totale en éléments d'impureté est égale à 1 ppm ou moins.

2. Élément destiné à être utilisé dans un équipement à semiconducteurs selon la revendication 1, dans lequel ledit additif de frittage non basé sur un métal est un composé organique qui produit du carbone lorsqu'il est chauffé.

3. Élément destiné à être utilisé dans un équipement à semiconducteurs selon la revendication 1, dans lequel la surface de la poudre de carbure de silicium est recouverte par ledit additif de frittage non basé sur un métal.

4. Élément destiné à être utilisé dans un équipement à semiconducteurs selon l'une quelconque des revendications 1 à 3, dans lequel ledit additif de frittage non basé sur un métal contient un composé organique qui produit du carbone lorsqu'il est chauffé, et une poudre de carbure de silicium, et la surface de la poudre de carbure de silicium est recouverte du composé organique.

5. Élément destiné à être utilisé dans un équipement à semiconducteurs selon l'une quelconque des revendications 1 à 4, dans lequel ledit additif de frittage non basé sur un métal est une résine phénolique.

6. Élément destiné à être utilisé dans un équipement à semiconducteurs selon l'une quelconque des revendications 1 à 5, dans lequel la résistance spécifique dudit corps fritté en carbure de silicium est de 1 $\Omega$.cm ou moins.

7. Élément destiné à être utilisé dans un équipement à semiconducteurs selon l'une quelconque des revendications 1 à 6, dans lequel la conductivité thermique dudit corps fritté en carbure de silicium est égale à au moins 200 W/m.k.

8. Élément destiné à être utilisé dans un équipement à semiconducteurs selon l'une quelconque des revendications 1 à 7, dans lequel ledit élément pour

F I G. 1A

F I G. 1B

F I G. 1C

F I G. 2 A

16

F I G. 2 B

18

F I G. 2 C

20

F I G. 2 D

22

F I G. 3